(19)

Europäisches
Patentamt
European
Patent Office
Office européen
des brevets

(11)     EP 2 058 854 B1

(12)     **EUROPEAN PATENT SPECIFICATION**

(45) Date of publication and mention
of the grant of the patent:
**03.12.2014  Bulletin 2014/49**

(21) Application number: **08167263.6**

(22) Date of filing: **22.10.2008**

(51) Int Cl.:
**H01L 21/82** *(2006.01)*      **H01L 27/06** *(2006.01)*
**H01L 27/07** *(2006.01)*      **H01L 21/04** *(2006.01)*
**H01L 29/16** *(2006.01)*

(54) **A semiconductor device**

Halbleiterbauelement

Dispositif semi-conducteur

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **07.11.2007  SE 0702446**

(43) Date of publication of application:
**13.05.2009  Bulletin 2009/20**

(73) Proprietor: **Acreo Swedish ICT AB
164 40 Kista (SE)**

(72) Inventors:
• **Bakowski, Mietek**
**SE-472 92, Stillingsön (SE)**
• **Schöner, Adolf**
**SE-165 74, Hässelby (SE)**
• **Ericsson, Per**
**SE-175 67, Järfälla (SE)**

(74) Representative: **Haag, Malina Anna et al
Awapatent AB
Södra Hamngatan 37-41
Box 11394
404 28 Göteborg (SE)**

(56) References cited:
EP-A1- 0 623 951      WO-A2-99/26296
WO-A2-2007/001316    DE-U1- 9 411 601
JP-A- 52 044 574     JP-A- 55 034 458
JP-A- 55 039 663     JP-A- 56 008 873
JP-A- 57 106 173     JP-A- 57 186 361
JP-A- 58 037 957     US-A- 6 097 046

• **AGARWAL A K ET AL: "Large area, 1.3 kV, 17 A,
bipolar junction transistors in 4H-SiC", 2003 IEEE
15TH. INTERNATIONAL SYMPOSIUM ON POWER
SEMICONDUCTOR DEVICES AND IC'S
PROCEEDINGS. CAMBRIDGE, UIK, APRIL 14 - 17,
2003; [INTERNATIONAL SYMPOSIUM ON
POWER SEMICONDUCTOR DEVICES & IC'S],
NEW YORK, NY : IEEE, US, 14 April 2003
(2003-04-14), pages 135-138, XP010653743, DOI:
10.1109/ISPSD.2003.1225248 ISBN:
978-0-7803-7876-6**

EP 2 058 854 B1

**Description**

TECHNICAL FIELD OF THE INVENTION AND PRIOR ART

The present invention relates to a semiconductor device of SiC according to the preamble of appended claim 1.

The invention is particularly but not exclusively directed to such a semiconductor device for high power applications where the semiconductor device may be able to take voltages above 500 V across the terminals thereof in a blocking state of the device. The superior properties of SiC in the form of a high breakdown field being approximately ten times higher than for Si and the excellent ability of SiC to withstand high temperatures may be utilized especially in high power applications involving high switching frequencies.

Important features of a semiconductor device of this type for functioning well as a switch is that it has to be able to handle high currents and high voltages and have low conducting losses, a low leakage current and change between conducting and blocking state while creating low losses, i.e. the turn-on and turn-off losses shall be low. It is also desired that the switch is switched off with no voltage applied to the control (gate) electrode, i.e. that it is normally-off.

A semiconductor device of the type defined in the introduction may thanks to the arrangement of said transistor be a normally-off device. Furthermore, it may also be designed to be able to block high voltages in the blocking state thereof thanks to the pn-junction thus formed by said buried grid regions and the drift layer depleted thereby, at the same time as the voltage in the blocking state of the device is kept at a low level over said transistor, so that this may be given a p-base with lower doping and smaller width and by that resulting in lower turn-on and turn-off losses than would be the case if this transistor had to be designed to withstand higher electric voltages.

A semiconductor device of the type defined in the introduction is already known through US patent 6 091 108. In spite of the advantages mentioned above of such a semiconductor device there is a desire to improve some properties of this device. The transistor of this known device is a MOSFET, in which an insulating layer in the form of a gate oxide is arranged for forming an inversion conducting channel therealong when a suitable voltage is applied to the gate of this transistor. However, the long time stability of the gate oxide may be questioned influencing the reliability of such a device. Furthermore, the channel mobility of such a device is not sufficiently high for keeping conducting losses as low as aimed at.

The documents WO 99/26296 and DE 9411601 U are further examples of high voltage SiC devices.

SUMMARY OF THE INVENTION

The object of the present invention is to provide a semiconductor device of SiC of the type defined in the introduction, which is improved in at least some aspect with respect to such semiconductor devices already known making it well suited as a switch for high power applications.

This object is obtained by providing such a semiconductor device, in which said transistor is a Bipolar Junction Transistor (BJT), in which upper regions of said drift layer form a collector layer of the transistor, the transistor further comprises a layer of said second conductivity type arranged on top of said drift layer and forming a base layer of the transistor, a gate electrode connected to said base layer, a highly doped layer of said first conductivity type arranged on top of said base layer and forming an emitter layer of the transistor, said second metal contact is arranged on said emitter layer, so that a cascode arrangement of a Bipolar Junction Transistor (BJT) and a Junction Field Effect Transistor (JFET) interconnecting said first and second terminal of the device is obtained.

The reliability of such a semiconductor device is high by using a transistor in the form of a Bipolar Junction Transistor having no gate oxide insulating layer. Very low turn-on, turn off and conducting losses may be obtained by using a BJT which has not to been dimensioned for high voltages in such a device. This means that the design of the base layer of the transistor most important for the turn-on, turn-off and conducting losses of the transistor may be dimensioned for low voltages, so that these losses may be kept on an attractively low level in spite of high voltages across said first and second terminal to be blocked by the entire device. More exactly, the base layer may be made low doped and narrow without risking occurrence of any punch-through phenomena, so that the current gain of the device will be very high. Furthermore, the embedded part of the device taking the major part of the voltage drop between the terminals in the blocking state of the semiconductor device will take care of excess charges upon turn-off, so that these will never pass through the gate electrode of the transistor, i.e. the Miller-capacitance will be discharged through the buried grid of the device connected to the emitter terminal and through the main circuit.

According to a most preferred embodiment of the invention the buried grid is directly connected to the emitter layer, which means that this grid is always on the same potential as the emitter contact of the device. This has several advantages. It means that there is only need for one gate drive unit connected to the gate contact and arranged to cause the device to switch between a conducting state and a blocking state by applying different voltages to the gate contact with respect to the emitter contact and bringing the BJT transistor between the second and the first state. This will simplify the construction and the control of the device. Furthermore, it enables high frequency operation at low losses, since the main Miller-capacitance will not be connected to any gate drive unit of the device. This means that the charge necessary to charge and discharge this Miller-capacitance does not need to be supplied by the gate driving unit but will be supplied by the main circuit. This also means that a so called buried grid diode will be connected in ant-parallel with the rest of the device, so that for instance in the case of using the device in a current valve in an inverter no separate so called anti-parallel diode is needed, but it's function will be integrated into the device itself.

According to a preferred embodiment of the invention the device comprises means for adjusting a potential of the gate electrode and the buried grid independently of each other. This may be achieved by two separate gate drive units, one each for the upper gate and for the buried grid. This results in an increased controllability of the device at switching.

According to an embodiment of the invention said first conductivity type is n. It has so far not been possible to obtain highly doped substrate layers of SiC with a p-type doping, so that today a device with better properties will be obtained by having the substrate layer, the drift layer and the emitter layer being of n-type, i.e. doped with donors, and the buried grid regions and the base layer of p-type, i.e. doped with acceptors.

According to another embodiment of the invention said drift layer portion of the device above said buried grid has a doping concentration above $1 \times 10^{14}$ cm$^{-3}$ and less than $1 \times 10^{16}$ cm$^{-3}$, less than $5 \times 10^{15}$ cm$^{-3}$, less than $2 \times 10^{15}$ cm$^{-3}$ or less than $1 \times 10^{15}$ cm$^{-3}$, which are suitable doping concentrations for blocking voltages of at least 1000 Volts, at least 2000 Volts, at least 5000 Volts and at least 8000 Volts, respectively, in good agree-ment with a well known relation $N_D = \dfrac{\varepsilon_0 \varepsilon_s \cdot E_c^2}{2q \cdot V_B}$

where $N_D$ is drift region doping, $V_B$ is breakdown voltage and $E_c$ is critical electric field strength equal to 2-2.5 x $10^6$ V/cm.

It is well known from the theory of bipolar transistor, BJT, that the current gain of the transistor increases as the product of the p-base width, $w_b$, and p-base doping concentration, $N_b$, decreases.

It is also well known from the theory of the p-n junction that following relations relating the width of the space charge of said p-base and drift region junction, $W_{sc}$, maximum electric field at the junction, $E_m$, space charge width at the said p-base side of the junction, $X_b$, and doping concentration at the p-base side of the junction, $N_b$, and applied voltage, $V_a$, apply:

$$w_{sc} = \sqrt{\frac{2\varepsilon_0\varepsilon_s}{q} \cdot \frac{N_b + N_D}{N_b \cdot N_D} \cdot V_a}$$

$$V_a = \frac{1}{2} E_m \cdot w_{sc}$$

$$x_b \cdot N_b = \frac{\varepsilon_0 \varepsilon_s}{q} \cdot E$$

According to another embodiment of the invention the said low voltage BJT transistor is designed to block a voltage from 20 Volts to 400 Volts, preferably from 20 Volts to 200 Volts and most preferred from 20 Volts to 50 Volts.

According to another embodiment of the invention the p-base region of the said BJT transistor is low doped and has a doping concentration of $5 \times 10^{16} - 1 \times 10^{18}$ cm$^{-3}$ and the device is designed to be able to block a voltage of at least 500 V or $1 \times 10^{16} - 1 \times 10^{18}$ cm$^{-3}$ and the device is designed to be able to block a voltage of at least 1000 V or $5 \times 10^{15} - 1 \times 10^{17}$ cm$^{-3}$ and the device is designed to be able to block a voltage of at least 2000 V or $2 \times 10^{15} - 1 \times 10^{17}$ cm$^{-3}$ and the device is designed to be able to block a voltage of at least 5000 V or $1 \times 10^{15} - 5 \times 10^{16}$ cm$^{-3}$ and the device is designed to be able to block a voltage of at least 8000 V.

According to another embodiment of the invention supported by the relations and conditions given above the product of the p-base width and p-base doping concentration of the low voltage BJT, $x_b \cdot N_b$, is less than $5 \times 10^{12}$ cm$^{-2}$ and the device is able to block a voltage of at least 500 V, less than $3 \times 10^{12}$ cm$^{-2}$ and the device is designed to be able to block a voltage of at least 1000 V, less than $2 \times 10^{12}$ cm$^{-2}$ and the device is designed to be able to block a voltage of at least 2000 V, less than $1.5 \times 10^{12}$ cm$^{-2}$ and the device is designed to be able to block a voltage of at least 5000 V and less than $1 \times 10^{12}$ cm$^{-2}$ and the device is designed to be able to block a voltage of at least 8000 V. This product of the p-base width and p-base doping concentration of the said transistor is 2.5 times less for the at least 500 V device, 4 times less for the at least 1000 V device, 7 times less for the at least 2000 V device, 9 times less for the at least 5000 V device and 13 times less for the at least 8000 V device compared to the required value for the high voltage BJT able to block the same voltages which is more than $1.3 \times 10^{13}$ cm$^{-3}$.

According to another embodiment of the invention the thickness of said base layer is 0.05-1.0 $\mu$m, advantageously 0.1-0.6 $\mu$m and most preferred 0.1-0.3 $\mu$m, which are thicknesses for a p-type base layer resulting in said low turn-on and turn-off losses, since the base layer may very fast be filled with or emptied from excess charges, respectively, through the gate electrode when turning the BJT on and off.

According to another embodiment of the invention the doping concentration of said emitter layer is $5 \times 10^{18} - 5 \times 10^{20}$ cm$^{-3}$, advantageously $1 \times 10^{19} - 1 \times 10^{20}$

$cm^{-3}$ and preferably $5 \times 10^{19}$ - $1 \times 10^{20}$ $cm^{-3}$. These are suitable doping concentrations for a n-type SiC emitter layer.

According to another embodiment of the invention the thickness of said emitter layer is 0.2-1 $\mu$m, advantageously 0.4-0.8 $\mu$m.

According to another embodiment of the invention the doping concentration of said grid regions is $5 \times 10^{17}$ - $5 \times 10^{20}$ $cm^{-3}$, preferably $1 \times 10^{18}$ - $1 \times 10^{20}$ $cm^{-3}$ and most preferred $5 \times 10^{18}$ - $1 \times 10^{20}$ $cm^{-3}$. These are suitable doping concentrations for such p-type grid regions for the electric field shielding function thereof and the creation of said anti-parallel diode in the blocking state of the device.

According to another embodiment of the invention the thickness of said buried grid regions is 0.2-2.0 $\mu$m.

According to yet another embodiment of the invention a lateral spacing between adjacent said buried grid regions is 1.5 $\mu$m - 8 $\mu$m or 2-6 $\mu$m. The voltage to be blocked in the blocking state of the device determines the size of this grid spacing since lower doping in the drift region is required for higher such voltages and since it takes lower grid potential to deplete the portions of the drift region inside the grid, so that a larger spacing is selected for higher such voltages in order to keep the potential required to close the grid at the same value, so that the grid spacing may for instance be 2 $\mu$m for an intended blocking voltage of 1000 V and 6 $\mu$m for a voltage of 10 kV.

According to another embodiment of the invention the thickness of the drift layer part separating said buried grid and said substrate layer is 5-100 $\mu$m. Also this thickness is dependent upon the voltage to be blocked in the blocking state of the device and will be larger for higher voltages.

According to another embodiment of the invention the doping concentration of said drift layer part separating said buried grid and said substrate layer is $1 \times 10^{14}$ - $5 \times 10^{16}$ $cm^{-3}$.

According to another embodiment of the invention said drift layer comprises two superimposed sub-layers, said upper regions of the drift layer are included in an upper sub-layer and the interface between this upper sub-layer and a lower sub-layer of the drift layer connects to said buried grid. This means that the two sub-layers may be differently doped, so that for instance the upper sub-layer may have a lower doping concentration than the lower sub-layer of the drift layer when desired for being more easily depleted by said buried grid regions, which constitutes another embodiment of the invention.

According to yet another embodiment of the invention said buried grid regions are located in said upper sub-layer while connecting to said interface between said upper and lower sub-layer of the drift layer. This will be the case when forming said buried grid regions by epitaxial growth, in which said lower substrate layer is first grown epitaxially and then a layer of opposite conductivity type is epitaxially grown on top thereof and patterned by for instance etching for forming said grid regions, whereupon said upper sub-layer is formed by an epitaxial regrowth by utilizing the very preferred "Embedded Epitaxi" (EE) method. This technique makes it possible to grow the upper sub-layer in the trenches or the like etched between the grid regions without any noticeable growth on the top of these grid regions, so that this upper sub-layer so formed may have a substantially flat upper surface. The semiconductor switch thus formed may be called a "EBEFET" (Embedded Bipolar Emitter Field Effect Transistor).

According to another embodiment of the invention said buried grid regions are located in said lower substrate layer while connecting to said interface between said upper and lower sub-layers of the drift layer. Such buried grid regions are then formed by implanting dopants of said second conductivity type into said lower sub-layer of said first conductivity type, whereupon the upper sub-layer is grown on top of said lower sub-layer. This also necessitates an annealing of the buried grid regions thus formed for making the dopants implanted electrically active. The annealing is conveniently performed during the epitaxial growth of the upper sub-layer of the drift region.

According to another embodiment of the invention the semiconductor device is designed to be able to block a voltage of at least 500 V, advantageously at least 2000 V, preferably at least 5000 V and most preferred at least 8000 V across said two terminals in a forward biased blocking state thereof. These are suitable voltages for a semiconductor device of this type, and the higher said voltage, i.e. the better blocking capability of the device, the larger is the reduction of turn-on losses of the device compared with a BJT designed for the same voltage.

According to another embodiment of the invention the spacing between adjacent said buried grid regions and the doping concentration of the regions of the drift layer separating said buried grid regions are selected so as to form a continuous layer of said second conductivity type through said grid regions shielding said Bipolar Junction Transistor (BJT) with respect to high voltages as of a collector-emitter-voltage ($U_{CE}$) being less than 200 V, advantageously less than 100 V and preferably less than 60 V, in a forward biased blocking state of the semiconductor device. By obtaining a shielding of the BJT as of such a voltage this may be given the excellent properties disclosed above in spite of a design of the semiconductor device for much higher voltages.

The invention also relates to a use of a semiconductor device according to the invention as a switch in high power applications, in which the switch has to be able to block a voltage of at least 500 V, advantageously at least 2000 V, preferably at least 5000 V and most preferred at least 8000 V across said two terminals in a forward biased blocking state thereof. An advantageous such use of the semiconductor device is as a current valve in an inverter, where it may be benefited form the superior properties thereof. This inverter may for instance be a part of an inverter station connecting to a power transmission network or connected between an electricity power source and a load, such as an electric motor.

According to an embodiment of the invention this use is for high switching frequencies, i.e. 10 Hz - 100 kHz, preferably 20 kHz - 50 kHz, where the semiconductor switch may be used also for high voltages thanks to the low switching and conduction losses and the thermal properties of SiC.

Further advantages and well as advantageous features of the invention will appear from the following description.

BRIEF DESCRIPTION OF THE DRAWINGS

With reference to the appended drawings, below follows a specific description of an embodiment of the invention cited as an example.

In the drawings:

Fig 1    is a simplified cross-section view of a semiconductor device according to an embodiment of the invention,

Fig 2    is a simplified perspective view of the semiconductor device according to Fig 1 with parts broken away for showing the construction of the device,

Fig 3    shows a symbol illustrating the construction and way of operation of the device shown in Figs 1 and 2,

Fig 4    is a simplified circuit diagram of an inverter in which semiconductor devices according to the present invention are built in as switches forming the entire current valves, and

Fig 5    shows a symbol illustrating the construction and way of operation of a device according to another embodiment of the invention.

DETAILED DESCRIPTION OF AN EMBODIMENT OF THE INVENTION

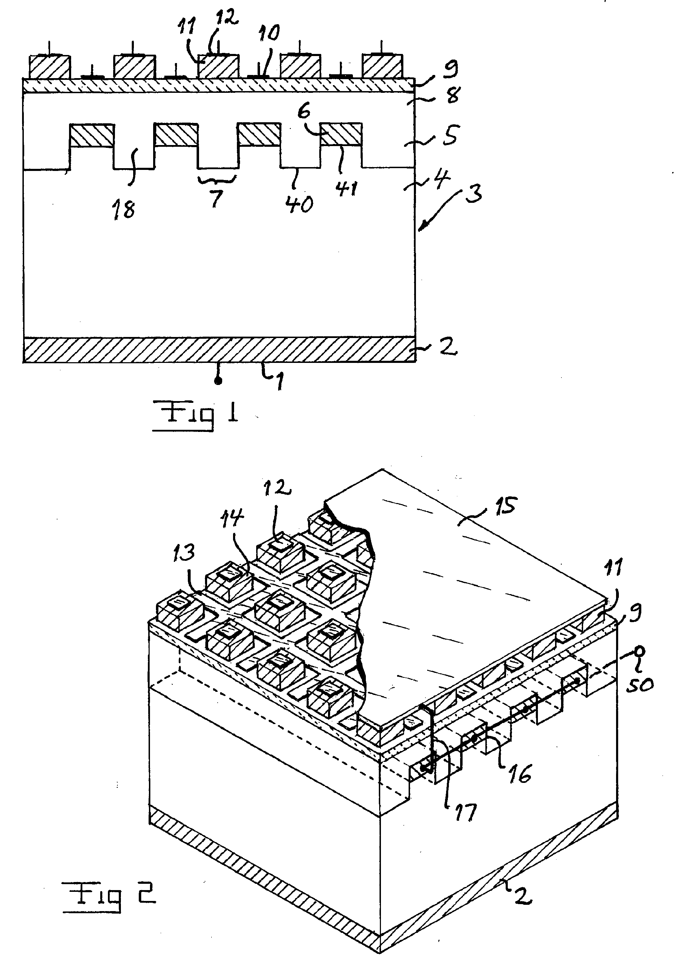

A semiconductor device of SiC in the form of a cascode arrangement of a Bipolar Junction Transistor (BJT) and a Junction Field Effect Transistor (JFET) according to the invention is illustrated in Fig 1. However, it should be noted that the relative dimensions of the layers and regions in this device shown in this Figure have only been chosen for the sake of clearness of the drawing. Such a device is adapted to function as a switch, especially in high power applications. This device has superimposed in the order mentioned: a first metal contact 1 forming a first terminal of the device, a said collector, a highly doped n-type substrate layer 2 having a dop-

ing concentration of $1 \times 10^{18}$ - $2 \times 10^{19}$ cm$^{-3}$ and a thickness of 100-400 $\mu$m. A low doped n-type drift layer 3 comprising a lower sub-layer 4 and an upper sub-layer 5 is arranged on top of the substrate layer 2. The sub-layer 4 has a doping concentration of $1 \times 10^{14}$ - $5 \times 10^{16}$ cm$^{-3}$ and a thickness of 5-100 $\mu$m, whereas the upper sub-layer 5 has doping concentration of $1 \times 10^{14}$ - $5 \times 10^{16}$ cm$^{-3}$ and a thickness of 1-3 $\mu$m. -type regions 6 are buried in said drift layer 3 while having drift layer portions thereabove and thereunder and forming a grid adapted to form a continuous layer of p-type in a blocking state of the semiconductor device and by that a pn-junction at a distance below an active region of a transistor thereabove (to be described further below) while taking a major part of the voltage drop across terminals of the device in a blocking state of the semiconductor device. The upper sub-layer 5 may have a lower doping concentration than the lower sub-layer 4 when desired for being more easily depleted by said buried grid regions 6. The grid regions 6 may have a doping concentration of $5 \times 10^{17}$ - $5 \times 10^{20}$cm$^{-3}$, preferably $1 \times 10^{18}$ - $1 \times 10^{20}$ cm$^{-3}$ and most preferred $5 \times 10^{18}$ - $1 \times 10^{20}$ cm$^{-3}$ and a thickness of 0.2 - 2.0 $\mu$m. Furthermore, the spacing 7 between adjacent grid regions is 1.5 $\mu$m - 8 $\mu$m or 2 $\mu$m - 6 $\mu$m, and it is selected to be the larger the higher said voltage to be blocked in the blocking state of the device is. In general design voltages between 500 V and 10 kV can be realized with a spacing varying only from 2 $\mu$m to 3 $\mu$m.

Said transistor above said buried grid is a Bipolar Junction Transistor (BJT), which has the upper regions 5 of the drift layer forming a collector layer 8 thereof. This transistor further comprises a p-type layer 9 arranged on top of the drift layer and forming a base layer of the transistor. This base layer has a doping concentration of $5 \times 10^{15}$ - $1 \times 10^{18}$ m$^{-3}$ and a thickness of 0.05-0.4 $\mu$m, advantageously 0.1-0.3 $\mu$m. A base electrode 10 is connected to the base layer forming a gate terminal of the device and a highly doped n-type layer forming an emitter layer 11 is arranged on top of the base layer. The emitter layer 11 has a doping concentration of $5 \times 10^{18}$ - $5 \times 10^{20}$ cm$^{-3}$, advantageously $1 \times 10^{19}$ - $1 \times 10^{20}$ cm$^{-3}$, and preferably $5 \times 10^{19}$ - $1 \times 10^{20}$ cm$^{-3}$. The thickness thereof is here 0.2-1 $\mu$m, advantageously 0.4-0.8 $\mu$m. A second metal contact 12 forming a second terminal of the device said emitter is arranged on the BJT emitter layer.

This device is formed by epitaxially growing the lower drift sub-layer 4 on top of the substrate layer 2. Then a p-type layer is grown on top of the layer 4 and after masking this is partially etched away for forming the grid regions 6. It is preferentially etched down for forming trenches that are deeper than the buried grid regions 6. The Embedded Epitaxi method described above is then utilized for growing the upper drift sub-layer 5, which is preferentially carried out for such deeper trenches, but it is also possible to use this technique for trenches having bottoms being aligned with the interface 41 between buried grid regions 6 and the lower drift sub-layer 4, whereupon the p-type base layer 9 is epitaxially grown thereupon. A highly doped n-type layer is then grown on top of the base layer, and it is after appropriate masking etched down to the base layer for making it possible to apply the gate electrode 10 thereto. The gate electrode 10 is then applied in the form of a grate 13 as shown in Fig 2. The second metal contact 12 is then applied on top of the emitter layer islands 14 by applying a metal plate 15 thereabove making contact to all of them. A metal contact 1 is also applied on the substrate layer and the emitter layer 15 is directly connected to the buried grid 16 formed by the regions 6, here in the form of bars, as illustrated by a contact piece 17 connecting the metal plate 15 to the buried grid.

Suitable donors are N and P and suitable acceptors are Al and B, but other dopants are conceivable.

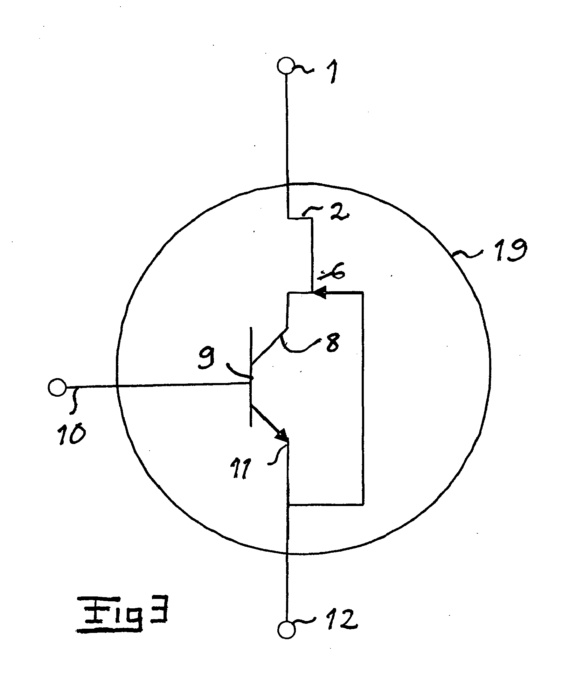

Thus cascode connection of a low voltage BJT and a high voltage JFET is formed in this way as illustrated through Fig 3. The layers 11, 9 and 8 form the emitter, base and collector of the BJT, in which 10 is the base electrode of the BJT and gate electrode of the entire device. Furthermore, the layers 5 and 2 form, respectively, the source and the drain of the JFET. At the same time the emitter electrode 12 of the BJT and the drain electrode 1 of the JFET constitute, respectively, the emitter and the collector electrodes of the entire device.

This device has also a built-in anti-parallel diode between the emitter electrode 12 and collector electrode 1 and formed between the embedded grid 16 and the drift layer 3.

The function of a device of this type is as follows with reference to Fig 1. The device is normally-off which means it is in the off-state when there is no voltage applied to the gate electrode. Assume the device is in the blocking state with high positive voltage applied to the collector terminal 1 of the device relative emitter terminal 12 of the device. The device can be turned-on by application of a positive voltage to the gate terminal 10 of the device relative the emitter electrode 12 which causes a hole current to flow through the gate electrode 10 into the base layer 9. This in turn makes the emitter-base pn junction to be forward biased which causes the injection of electrons from the emitter layer 11 into the base layer 9 and further into the collector region 5 of the low voltage BJT part of the structure. The electrons are then transported further towards the collector electrode 1 of the device by drift mechanism due to the electric field present in the drift region 3 of the high voltage JFET part of the structure due to the depletion region created by the blocking voltage and compensate the positively charged donors present in the named depletion region recharging the Miller-capacitance and causing the depletion region and the voltage over the device to collapse. The turn-on losses of the described turn-on process will be very low thanks to the thin and low doped p-base layer 9 of the BJT which causes the injection of the electrons from the emitter layer 11 to be very efficient. The on-state voltage across the terminals of the device will now in the conduction state of the device be approximately 1 Volt. The device can be turned-off by application of the negative voltage to the gate terminal 10 of the device relative emitter terminal 12 of the device which causes the hole current to flow out of the base layer 9 through the gate contact 10 and out of the regions 4 and 5 through the buried grid 6 leading to the removal of the excess holes from the base layer and layers 4 and 5. Removal of the excess positive charge from base layer 9 causes the injection of the electrons from the emitter layer to cease which makes it possible for the depletion region in the layers 4 and 5 to be formed again taking up the applied blocking voltage. The removal of the excess charge from the device layers 4 and 5 is now accelerated as the excess electrons are being swept towards the collector electrode 1 and the excess holes towards the buried grid by the expanding space charge region which corresponds to recharging of the Miller-capacitance by the external circuit. The device is now entering the forward blocking state. The turn-off losses of the described turn-off process will be very low thanks to the thin and low doped p-base layer 9 of the BJT which causes the amount of positive excess charge that has to be removed from the base layer 9 to be very low thus making the turn-off process very fast. When the device is in a forward blocking state the depletion region surrounding the buried grid regions 6 will be expanded by the voltage applied across the terminals and by that across this buried grid regions directly connected to the second terminal 12 and the first terminal 1, so that the regions 18 between adjacent buried grid regions will be totally depleted and by that a pn-junction will be formed in the drift layer 3, more exactly in the lower sub-layer 4 thereof. This pn-junction will act as a potential divider and take a major part of the voltage drop across said two terminals 1, 12, so that the BJT of the device will be shielded against high electric fields, which makes it possible to construct this BJT for low voltages even if the device itself is intended for high voltage applications.

Thus, it may for a device intended to block for example 5000 V in a forward biased blocking state be possible to design the BJT with a blocking capability of 100 V, since it will only take 50 V before the layer 5 is depleted and the pn-junction will take the rest of the voltage across the terminals of the device.

The inventors have compared a semiconductor device according to the invention designed for blocking 3.3 kV in the forward blocking state thereof and having an area of 1 cm$^2$ when switching a current of 100 A and a forward blocking voltage of 2500 V with a BJT designed for 3.3 kV blocking voltage. The turn-on losses of the semiconductor device according to the invention has turned out to be about 100 times lower, the turn-off losses about 6 times lower and the switching losses about 20 times lower than for the BJT. Furthermore, the gate on-state current required to keep the device in saturation is 5 times lower than for the BJT. It is pointed out that these differences increase with said blocking voltage.

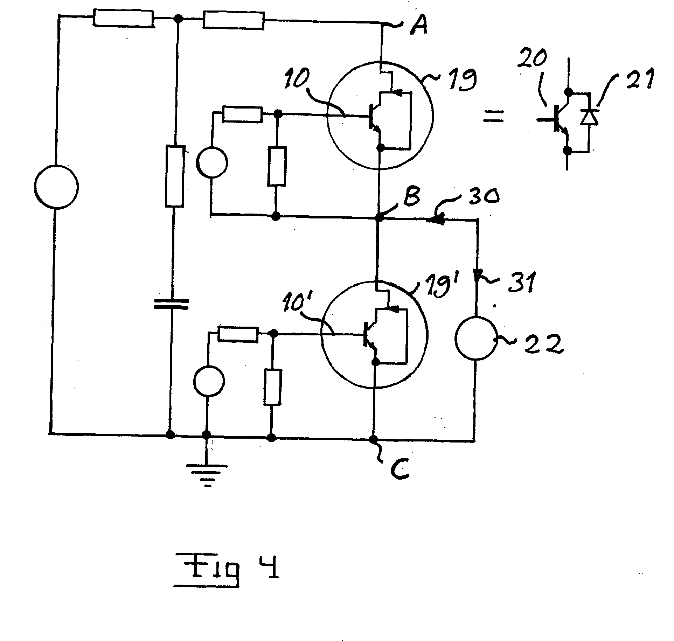

Fig 4 illustrates a preferred use of the semiconductor device according to the invention, which is depicted through the symbols 19, 19'. Each semiconductor device here forms a current valve in an inverter while functioning as a high voltage BJT 20 having an internal freewheeling diode 21 connected in anti-parallel therewith. The function of an inverter of this type is well known and will here only be briefly summarized. When the semiconductor device 19' is conducing and the semiconductor device 19 is off the potential in the point A is for instance 1200 V and in the point B about 1 V, which constitutes a forward conducting voltage drop of the semiconductor device 19' having the potential 0 V on the opposite direct voltage side C of the inverter. The direction of the current flow is now into the inverter as shown through the arrow 30. The semiconductor device 19' is now turned off by applying a negative voltage to the gate electrode 10'. However, the current continues to flow into the inverter due to the inductive nature of a load 22 connected to the alternating voltage side of the inverter and the potential in the point B has to rise until it reaches 1202.5 V and the built-in diode 21, which has an on-state voltage of 2.5 V, in the semiconductor device 19 takes over the current. Turning on this semiconductor device 19 by applying a positive voltage to the gate electrode 10 opens in its turn a path for the current through the device 19 when the direction of the load current changes from the inverter and towards the load 22 as illustrated by the arrow 31. The potential in the point B becomes now about 1199 V due to the on-state voltage drop over the device 19. When the device 19 is turned off by applying a negative gate voltage to the gate 10 the voltage in the point B is forced to decrease until it reaches a value of about -2.5 V, and the built-in diode 21 of the device 19' will then take over the current flowing out from the inverter towards the load 22.

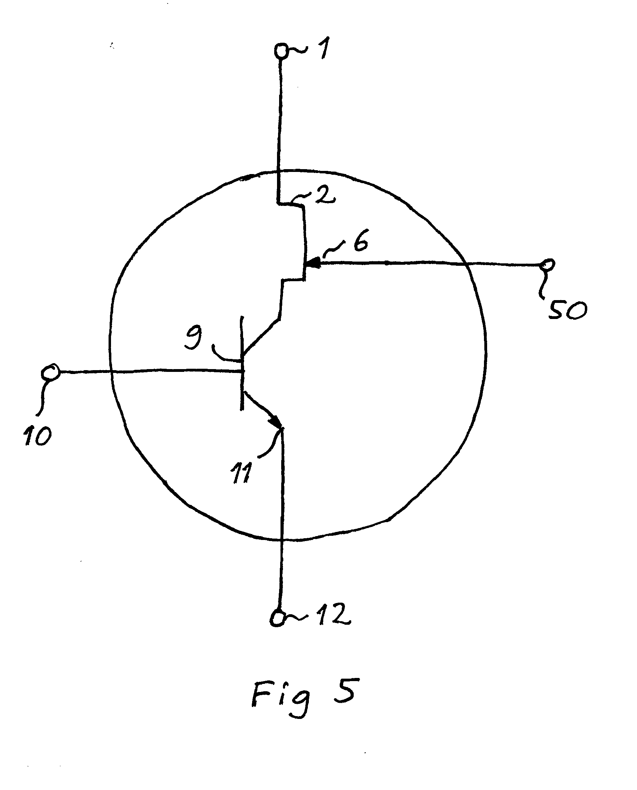

A semiconductor device according to another embodiment of the invention being slightly modified with respect to the embodiment described above is indicated in Fig 2. In this embodiment the contact piece 17 connecting the buried grid 16 to the emitter layer 11 is not there, but a further gate electrode 50 is instead connected to the buried grid 16, so that means are created for adjusting a potential of the gate electrode 10 and the buried grid 16 independently of each other. This may be achieved by two separate gate drive units, one each for the upper gate 10 and for the buried grid 16. This results in an increased controllability of the device at switching. The symbol illustrating the construction and way of operation of such a device is shown in Fig 5.

It is pointed out that the invention is of course not in any way restricted to the embodiment described above, but many possibilities to modifications thereof will be apparent to a person with ordinary skill in the art without departing from the basic idea of the invention as defined in the appended claims.

It would for example be possible to form said buried grid regions by implantation instead of epitaxial growth.

The buried grid may have another appearance than shown in the Figures, such as being formed by interconnected islands, a grating, concentric rings and so on. The same is valid for the structure of the emitter.

Furthermore, it is within the scope of the present invention to have p as said first conductivity type and n as said second conductivity type.

## Claims

1.    A semiconductor device of SiC comprising superimposed in the order mentioned:

• a first metal contact (1) forming a first terminal of the device,
• a highly doped substrate layer (2) being of a first conductivity type, n or p,
• a low doped drift layer (3) being of said first conductivity type,
• a transistor, which may have at least a part of said drift layer included therein, and
• a second metal contact (12) connecting to said transistor for forming a second terminal of the device, said device being adapted to conduct a current therethrough between said two terminals in a conducting state thereof,
said device also comprising regions (6) laterally spaced and forming a grid (16) being doped according to a second conductivity type being opposite to said first conductivity type and buried in said drift layer (3) while having drift layer portions there-above and thereunder and adapted to form a continuous layer of said second conductivity type in a blocking state of the semiconductor device and by that a pn-junction at a distance below an active region of said transistor taking a major part of the voltage drop across said terminals (1, 12) in said blocking state of the semiconductor device,
**characterized in that** said transistor is a Bipolar Junction Transistor (BJT), in which upper regions of said drift layer form a collector layer (8) of the transistor, that the transistor further comprises a layer of said second conductivity type arranged on top of said drift layer and forming a base layer (9) of the transistor, a gate electrode (10) connected to said base layer, a highly doped layer of said first conductivity type arranged on top of said base layer and forming an emitter layer (11) of the transistor, and that said second metal contact (12) is arranged on said emitter layer, so that a cascode arrangement of a low voltage Bipolar Junction Transistor (BJT) and a high voltage Junction Field Effect Transistor (JFET) interconnecting said first and second terminal of the device is obtained.

**2.** A semiconductor device according to claim 1, **characterized in that** said buried grid (16') is directly connected to said emitter layer (11).

**3.** A semiconductor device according to claim 1, **characterized in that** it comprises means for adjusting a potential of said gate electrode (10) and said buried grid (16) independently of each other.

**4.** A semiconductor device according to any of claims 1-3, **characterized in that** said first conductivity type is n.

**5.** A semiconductor device according to claim 4, **characterized in that** said drift layer portion (5) of the device above said buried grid (16) has a doping concentration above $1 \times 10^{14}$ cm$^{-3}$ and less than $1 \times 10^{16}$ cm$^{-3}$, less than $5 \times 10^{15}$ cm$^{-3}$, less than $2 \times 10^{15}$ cm$^{-3}$ or less than $1 \times 10^{15}$ cm$^{-3}$.

**6.** A semiconductor device according to any of the preceding claims, **characterized in that** said low voltage Bipolar Junction Transistor (BJT) is designed to block a voltage from 20 Volts to 400 Volts, preferably from 20 Volts to 200 Volts and most preferred from 20 Volts to 50 Volts.

**7.** A semiconductor device according to claim 4, **characterized in that** said base layer (9) of said Bipolar Junction Transistor (BJT) is low doped and has a doping concentration of $5 \times 10^{16}$ - $1 \times 10^{18}$ cm$^{-3}$ and the device is designed to be able to block a voltage of at least 1000 V or $5 \times 10^{15}$ - $1 \times 10^{17}$ cm$^{-3}$ and the device is designed to be able to block a voltage of at least 2000 V or $2 \times 10^{15}$ - $1 \times 10^{17}$ cm$^{-3}$ and the device is designed to be able to block a voltage of at least 5000 V or $1 \times 10^{15}$ - $5 \times 10^{16}$ cm$^{-3}$ and the device is designed to be able to block a voltage of at least 8000 V.

**8.** A semiconductor device according to claim 7, **characterized in that** the product of the width of said base layer (9) and the base layer doping concentration of the low voltage Bipolar Junction Transistor (BJT), $x_b \cdot N_b$, is less than $5 \times 10^{12}$ cm$^{-2}$ and the device is able to block a voltage of at least 500 V, less than $3 \times 10^{12}$ cm$^{-2}$ and the device is designed to be able to block a voltage of at least 1000 V, less than $2 \times 10^{12}$ cm$^{-2}$ and the device is designed to be able to block a voltage of at least 2000 V, less than $1.5 \times 10^{12}$ cm$^{-2}$ and the device is designed to be able to block a voltage of at least 5000 V and less than $1 \times 10^{12}$ cm$^{-2}$ and the device is designed to be able to block a voltage of at least 8000 V.

**9.** A semiconductor device according to claim 7 or 8, **characterized in that** the thickness of said base layer (9) is 0.05-1.0 $\mu$m, advantageously 0.1-0.6 $\mu$m and most preferred 0.1-0.3 $\mu$m.

**10.** A semiconductor device according to any of the preceding claims, **characterized in that** said drift layer comprises two superimposed sub-layers, that said upper regions (8) of the drift layer are included in an upper sub-layer (5), that the interface between this upper sub-layer (5) and a lower sub-layer (4) of the drift layer connects to said buried grid (16), and that said buried grid regions (6) are located in said lower sub-layer while connecting to said interface between said upper and lower sub-layers of the drift layer.

**11.** A semiconductor device according to any of the preceding claims, **characterized in that** it is designed to be able to block a voltage of at least 500 V, advantageously at least 2000 V, preferably at least 5000 V and most preferred at least 8000 V across said two terminals (1, 12) in a forward biased blocking state thereof.

**12.** A semiconductor device according to any of the preceding claims, **characterized in that** the spacing (7) between adjacent said buried grid regions (6) and the doping concentration of the regions (18) of the drift layer separating said buried grid regions are selected so as to form a continuous layer of said second conductivity type through said grid regions shielding said Bipolar Junction Transistor (BJT) with respect to high voltages as of a collector-emitter-voltage ($U_{CE}$) being less than 200 V, advantageously less than 100 V and preferably less than 60 V, in a forward biased blocking state of the semiconductor device.

**13.** Use of a semiconductor device according to any of claims 1-11 as a switch (19, 19') in high power applications, in which the switch has to be able to block a voltage of at least 500 V, advantageously at least 2000 V, preferably at least 5000 V and most preferred at least 8000 V across said two terminals (1, 12) in a forward biased blocking state thereof.

**14.** Use according to claim 13 of the semiconductor device as a current valve in an inverter.

**15.** Use according to claim 13 or 14 of the semiconductor device for high switching frequencies, i.e. 10 kHz - 100 kHz, preferably 20 kHz - 50 kHz.

**Patentansprüche**

**1.** Halbleiterbauelement aus SiC, das - in folgender Reihenfolge übereinander - Folgendes umfasst:

　　• einen ersten Metallkontakt (1), der einen ersten Anschluss des Bauelements bildet,
　　• eine stark dotierte Substratschicht (2) eines ersten Leitfähigkeitstyps, n oder p,
• eine gering dotierte Driftschicht (3) des ersten Leitfähigkeitstyps,
• einen Transistor, in dem mindestens ein Teil der Driftschicht enthalten sein kann, und
• einen zweiten Metallkontakt (12), der mit dem Transistor verbunden ist, um einen zweiten Anschluss des Bauelements zu bilden, wobei das Bauelement dafür ausgelegt ist, durch sich hindurch einen Strom zwischen den beiden Anschlüssen, wenn sie sich in einem leitenden Zustand befinden, zu leiten,
wobei das Bauelement des Weiteren Regionen (6) umfasst, die seitlich voneinander beabstandet sind und ein Gitter (16) bilden, das gemäß einem zweiten Leitfähigkeitstyp dotiert ist, der dem ersten Leitfähigkeitstyp entgegengesetzt ist, und in der Driftschicht (3) vergraben ist, während es Driftschichtabschnitte darüber und darunter aufweist und dafür ausgelegt ist, eine durchgehende Schicht des zweiten Leitfähigkeitstyps in einem Sperrzustand des Halbleiterbauelements zu bilden, wodurch ein p-n-Übergang in einer Entfernung unterhalb einer aktiven Region des Transistors einen Großteil des Spannungsabfalls an den Anschlüssen (1, 12) in dem Sperrzustand des Halbleiterbauelements aufnimmt,
**dadurch gekennzeichnet, dass** der Transistor ein Bipolar-Sperrschichttransistor (BJT) ist, in dem obere Regionen der Driftschicht eine Kollektor-Schicht (8) des Transistors bilden, und dass der Transistor des Weiteren eine Schicht des zweiten Leitfähigkeitstyps umfasst, die auf der Driftschicht angeordnet ist und eine Basisschicht (9) des Transistors bildet, wobei eine Steuerelektrode (10) mit der Basisschicht verbunden ist, wobei eine stark dotierte Schicht des ersten Leitfähigkeitstyps auf der Basisschicht angeordnet ist und eine Emitterschicht (11) des Transistors bildet; und dass der zweite Metallkontakt (12) auf der Emitterschicht angeordnet ist, so dass eine Kaskodenanordnung eines Niedrigspannungs-Bipolar-Sperrschichttransistors (BJT) und eines Hochspannungs-Sperrschicht-Feldeffekttransistors (JFET), die den ersten und den zweiten Anschluss des Bauelements miteinander verbindet, erhalten wird.

2. Halbleiterbauelement nach Anspruch 1, **dadurch gekennzeichnet, dass** das vergrabene Gitter (16') direkt mit der Emitterschicht (11) verbunden ist.

3. Halbleiterbauelement nach Anspruch 1, **dadurch gekennzeichnet, dass** es ein Mittel zum Justieren eines Potenzials der Steuerelektrode (10) und des vergrabenen Gitters (16) unabhängig voneinander umfasst.

4. Halbleiterbauelement nach einem der Ansprüche 1 - 3, **dadurch gekennzeichnet, dass** der erste Leitfähigkeitstyp n ist.

5. Halbleiterbauelement nach Anspruch 4, **dadurch gekennzeichnet, dass** der Driftschichtabschnitt (5) des Bauelements oberhalb des vergrabenen Gitters (16) eine Dotierungskonzentration höher als $1 \times 10^{14}$ cm$^{-3}$ und niedriger als $1 \times 10^{16}$ cm$^{-3}$, niedriger als $5 \times 10^{15}$ cm$^{-3}$, niedriger als $2 \times 10^{15}$ cm$^{-3}$ oder niedriger als $1 \times 10^{15}$ cm$^{-3}$ hat.

6. Halbleiterbauelement nach einem der vorangehenden Ansprüche, **dadurch gekennzeichnet, dass** der Niedrigspannungs-Bipolar-Sperrschichttransistor (BJT) dafür ausgelegt ist, eine Spannung von 20 Volt bis 400 Volt, bevorzugt von 20 Volt bis 200 Volt und ganz besonders bevorzugt von 20 Volt bis 50 Volt zu sperren.

7. Halbleiterbauelement nach Anspruch 4, **dadurch gekennzeichnet, dass** die Basisschicht (9) des Bipolaren Sperrschichttransistors (BJT) gering dotiert ist und eine Dotierungskonzentration von $5 \times 10^{16}$ - $1 \times 10^{18}$ cm$^{-3}$ hat und das Bauelement dafür ausgelegt ist, eine Spannung von mindestens 1000 V sperren zu können, oder von $5 \times 10^{15}$ - $1 \times 10^{17}$ cm$^{-3}$ hat und das Bauelement dafür ausgelegt ist, eine Spannung von mindestens 2000 V sperren zu können, oder von $2 \times 10^{15}$ - $1 \times {}_{10}{}^{17}$ cm$^{-3}$ hat und das Bauelement dafür ausgelegt ist, eine Spannung von mindestens 5000 V sperren zu können, oder von $1 \times 10^{15}$ - $5 \times 10^{16}$ cm$^{-3}$ hat und das Bauelement dafür ausgelegt ist, eine Spannung von mindestens 8000 V sperren zu können.

8. Halbleiterbauelement nach Anspruch 7, **dadurch gekennzeichnet, dass** das Produkt der Breite der Basisschicht (9) und der Basisschicht-Dotierungskonzentration des Niedrigspannungs-Bipolar-Sperrschichttransistors (BJT), $x_b \cdot N_b$, kleiner als $5 \times 10^{12}$ cm$^{-2}$ ist und das Bauelement eine Spannung von mindestens 500 V sperren kann, kleiner als $3 \times 10^{12}$ cm$^{-2}$ ist und das Bauelement dafür ausgelegt ist, eine Spannung von mindestens 1000 V sperren zu können, kleiner als $2 \times 10^{12}$ cm$^{-2}$ ist und das Bauelement dafür ausgelegt ist, eine Spannung von mindestens 2000 V sperren zu können, kleiner als $1,5 \times 10^{12}$ cm$^{-2}$ ist und das Bauelement dafür ausgelegt ist, eine Spannung von mindestens 5000 V sperren zu können, und kleiner als $1 \times 10^{12}$ cm$^{-2}$ ist und das Bauelement dafür ausgelegt ist, eine Spannung von mindestens 8000 V sperren zu können.

9. Halbleiterbauelement nach Anspruch 7 oder 8, **dadurch gekennzeichnet, dass** die Dicke der Basisschicht (9) 0,05 - 1,0 $\mu$m, bevorzugt 0,1 - 0,6 $\mu$m und ganz besonders bevorzugt 0,1- 0,3 $\mu$m beträgt.

**10.** Halbleiterbauelement nach einem der vorangehenden Ansprüche, **dadurch gekennzeichnet, dass** die Driftschicht zwei übereinandergelegte Teilschichten umfasst, dass die oberen Regionen (8) der Driftschicht in einer oberen Teilschicht (5) enthalten sind, dass die Grenzfläche zwischen dieser oberen Teilschicht (5) und einer unteren Teilschicht (4) der Driftschicht mit dem vergrabenen Gitter (16) verbunden ist, und dass sich die vergrabenen Gitterregionen (6) in der unteren Teilschicht befinden, während sie mit der Grenzfläche zwischen der oberen und der unteren Teilschicht der Driftschicht verbunden sind.

**11.** Halbleiterbauelement nach einem der vorangehenden Ansprüche, **dadurch gekennzeichnet, dass** es dafür ausgelegt ist, eine Spannung von mindestens 500 V, bevorzugt mindestens 2000 V, besonders bevorzugt mindestens 5000 V und ganz besonders bevorzugt mindestens 8000 V an den beiden Anschlüssen (1, 12) sperren zu können, wenn sie sich in einem in Durchlassrichtung vorgespannten Sperrzustand befinden.

**12.** Halbleiterbauelement nach einem der vorangehenden Ansprüche, **dadurch gekennzeichnet, dass** die Beabstandung (7) zwischen den benachbarten vergrabenen Gitterregionen (6) und die Dotierungskonzentration der Regionen (18) der Driftschicht, welche die vergrabenen Gitterregionen trennen, so gewählt sind, dass eine durchgehende Schicht des zweiten Leitfähigkeitstyps durch die Gitterregionen gebildet wird, die den Bipolaren Sperrschichttransistor (BJT) mit Bezug auf hohe Spannungen wie von einer Kollektor-Emitter-Spannung ($U_{CE}$) von weniger als 200 V, bevorzugt weniger als 100 V und ganz besonders bevorzugt weniger als 60 V in einem in Durchlassrichtung vorgespannten Sperrzustand des Halbleiterbauelements abschirmt.

**13.** Verwendung eines Halbleiterbauelement nach einem der Ansprüche 1 - 11 als einen Schalter (19, 19') in Starkstromanwendungen, bei denen der Schalter in der Lage sein muss, eine Spannung von mindestens 500 V, bevorzugt mindestens 2000 V, besonders bevorzugt mindestens 5000 V und ganz besonders bevorzugt mindestens 8000 V an den beiden Anschlüssen (1, 12) zu sperren, wenn sie sich in einem in Durchlassrichtung vorgespannten Sperrzustand befinden.

**14.** Nutzung des Halbleiterbauelements nach Anspruch 13 als ein Stromventil in einem Wechselrichter.

**15.** Nutzung des Halbleiterbauelements nach Anspruch 13 oder 14 für hohe Schaltfrequenzen, d. h. 10 kHz - 100 kHz, bevorzugt 20 kHz - 50 kHz.

**Revendications**

**1.** Dispositif semi-conducteur de SiC comprenant en superposition dans l'ordre suivant :

- un premier contact métallique (1) constituant une première borne du dispositif,
- une couche de substrat fortement dopée (2) étant d'un premier type de conductivité, n ou p,
- une couche de dérive faiblement dopée (3) étant dudit premier type de conductivité,
- un transistor, dans lequel au moins une partie de ladite couche de dérive peut être incluse, et
- un deuxième contact métallique (12) se reliant au dit transistor pour constituer une deuxième borne du dispositif, ledit dispositif étant apte à conduire un courant à travers celui-ci entre lesdites deux bornes dans un état de conduction de celui-ci,

ledit dispositif comprenant également des régions (6) espacées latéralement et constituant un réseau (16) qui est dopé en fonction d'un deuxième type de conductivité opposé au dit premier type de conductivité et qui est enfoui dans ladite couche de dérive (3) tout en ayant des portions de couche de dérive qui se trouvent au-dessus et au-dessous de celui-ci, et apte à former une couche continue dudit deuxième type de conductivité dans un état de blocage du dispositif semi-conducteur, et une jonction pn à une distance au-dessous d'une région active dudit transistor prenant une partie majeure de la baisse de tension entre lesdites bornes (1, 12) dans ledit état de blocage du dispositif semi-conducteur,

**caractérisé en ce que** ledit transistor est un transistor à jonction bipolaire (BJT), dans lequel des régions supérieures de ladite couche de dérive constituent une couche collectrice (8) du transistor, le transistor comprend en outre une couche dudit deuxième type de conductivité agencée dessus ladite couche de dérive et constituant une couche de base (9) du transistor, une électrode de grille (10) reliée à ladite couche de base, une couche fortement dopée dudit premier type de conductivité agencée dessus ladite couche de base et constituant une couche émettrice (11) du transistor, et ledit deuxième contact métallique (12) est agencé sur ladite couche émettrice, de manière à obtenir un agencement en cascade d'un transistor à jonction bipolaire (BJT) de basse tension et un transistor à effet de champ (JFET) de haute tension interconnectant ladite première borne et ladite deuxième borne du dispositif.

**2.** Dispositif semi-conducteur selon la revendication 1, **caractérisé en ce que** ledit réseau enfoui (16') est directement relié à ladite couche émettrice (11).

3. Dispositif semi-conducteur selon la revendication 1, **caractérisé en ce qu'**il comprend des moyens pour ajuster un potentiel de ladite électrode de grille (10) et dudit réseau enfoui (16) indépendamment l'un de l'autre.

4. Dispositif semi-conducteur selon l'une quelconque des revendications 1 - 3, **caractérisé en ce que** ledit premier type de conductivité est n.

5. Dispositif semi-conducteur selon la revendication 4, **caractérisé en ce que** ladite portion de couche de dérive (5) du dispositif au-dessus dudit réseau enfoui (16) a une concentration de dopage supérieure à 1 x $10^{14}$ cm$^{-3}$ et inférieure à 1 x $10^{16}$ cm$^{-3}$, inférieure à 5 x $10^{15}$ cm$^{-3}$, inférieure à 2 x $10^{15}$ cm$^{-3}$ ou inférieure à 1 x $10^{15}$ cm$^{-3}$.

6. Dispositif semi-conducteur selon l'une quelconque des revendications précédentes, **caractérisé en ce que** ledit transistor à jonction bipolaire (BJT) de basse tension est conçu pour bloquer une tension de 20 volts à 400 volts, de préférence de 20 volts à 200 volts et avec le plus de préférence de 20 volts à 50 volts.

7. Dispositif semi-conducteur selon la revendication 4, **caractérisé en ce que** ladite couche de base (9) dudit transistor à jonction bipolaire (BJT) est faiblement dopée et a une concentration de dopage de 5 x $10^{16}$ à 1 x $10^{18}$ cm$^{-3}$ et le dispositif est conçu pour pouvoir bloquer une tension d'au moins 1000 volts ou de 5 x $10^{15}$ à 1 x $10^{17}$ cm$^{-3}$ et le dispositif est conçu pour pouvoir bloquer une tension d'au moins 2000 volts ou de 2 x $10^{15}$ à 1 x $10^{17}$ cm$^{-3}$ et le dispositif est conçu pour pouvoir bloquer une tension d'au moins 5000 volts ou de 1 x $10^{15}$ à 5 x $10^{16}$ cm$^{-3}$ et le dispositif est conçu pour pouvoir bloquer une tension d'au moins 8000 volts.

8. Dispositif semi-conducteur selon la revendication 7, **caractérisé en ce que** le produit de la largeur de ladite couche de base (9) et la concentration de dopage de couche de base du transistor à jonction bipolaire (BJT) de basse tension, $x_b \cdot N_b$, est inférieur à 5 x $10^{12}$ cm$^{-2}$ et le dispositif est capable de bloquer une tension d'au moins 500 volts, inférieur à 3 x $10^{12}$ cm$^{-2}$ et le dispositif est conçu pour pouvoir bloquer une tension d'au moins 1000 volts, inférieur à 2 x $10^{12}$ cm$^{-2}$ et le dispositif est conçu pour pouvoir bloquer une tension d'au moins 2000 volts, inférieur à 1,5 x $10^{12}$ cm$^{-2}$ et le dispositif est conçu pour pouvoir bloquer une tension d'au moins 5000 volts, et inférieur à 1 x $10^{12}$ cm$^{-2}$ et le dispositif est conçu pour pouvoir bloquer une tension d'au moins 8000 volts.

9. Dispositif semi-conducteur selon la revendication 7 ou 8, **caractérisé en ce que** l'épaisseur de ladite couche de base (9) est de 0,05 - 1,0$\mu$ m, de manière avantageuse de 0,1 - 0,6 $\mu$m et avec le plus de préférence de 0,1 - 0,3 $\mu$m.

10. Dispositif semi-conducteur selon l'une quelconque des revendications précédentes, **caractérisé en ce que** ladite couche de dérive comprend deux sous-couches superposées, lesdites régions supérieures (8) de la couche de dérive sont incluses dans une sous-couche supérieure (5), l'interface entre cette sous-couche supérieure (5) et une sous-couche inférieure (4) de la couche de dérive se relie au dit réseau enfoui (16), et lesdites régions de réseau enfoui (6) sont situées dans ladite sous-couche inférieure tout en se reliant à ladite interface entre ladite sous-couche supérieure et ladite sous-couche inférieure de la couche de dérive.

11. Dispositif semi-conducteur selon l'une quelconque des revendications précédentes, **caractérisé en ce qu'**il est conçu pour pouvoir bloquer une tension d'au moins 500 volts, de manière avantageuse d'au moins 2000 volts, de préférence d'au moins 5000 volts et avec le plus de préférence d'au moins 8000 volts entre lesdites deux bornes (1, 12) dans un état de blocage à polarisation sans voie de retour de celui-ci.

12. Dispositif semi-conducteur selon l'une quelconque des revendications précédentes, **caractérisé en ce que** l'espacement (7) entre lesdites régions de réseau enfoui (6) adjacentes et la concentration de dopage des régions (18) de la couche de dérive séparant lesdites régions de réseau enfoui sont sélectionnés de manière à constituer une couche continue dudit deuxième type de conductivité à travers lesdits régions de réseau protégeant ledit transistor à jonction bipolaire (BJT) des hautes tensions, comme d'une tension de collecteur-émetteur ($U_{CE}$) inférieure à 200 volts, de manière avantageuse inférieure à 100 volts et de préférence inférieure à 60 volts, dans un état de blocage à polarisation sans voie de retour du dispositif semi-conducteur.

13. Utilisation d'un dispositif semi-conducteur selon l'une quelconque des revendications 1 - 11 sous la forme d'un commutateur (19, 19') dans des applications de forte puissance, dans laquelle le commutateur doit pouvoir bloquer une tension d'au moins 500 volts, de manière avantageuse d'au moins 2000 volts, de préférence d'au moins 5000 volts et avec le plus de préférence d'au moins 8000 volts entre lesdites deux bornes (1, 12) dans un état de blocage à polarisation sans voie de retour de celui-ci.

14. Utilisation selon la revendication 13 du dispositif semi-conducteur sous la forme d'une vanne de courant dans un inverseur.

15. Utilisation selon la revendication 13 ou 14 du dispositif semi-conducteur pour de hautes fréquences de commutation, c'est-à-dire de 10 kHz à 100 kHz, de préférence de 20 kHZ à 50 kHz.

Fig 1

Fig 2

Fig 3

14

Fig 4



Fig 5

**EP 2 058 854 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6091108 A
- WO 9926296 A
- DE 9411601 U